# EUROPEAN PATENT APPLICATION

(11) **EP 1 619 848 A1**
(43) Date of publication of application: **25.01.2006**
(21) Application number: 04291852.4
(22) Date of filing: 21.07.2004
(51) Int. Cl.: H04L 27/36, H03C 3/40

(54) **RADIO FREQUENCY TRANSMITTER AND METHOD OF OPERATING A RADIO FREQUENCY TRANSMITTER**

(71) Applicant: Evolium S.A.S., 75008 Paris (FR)
(72) Inventor: Schütz, Thomas, 71229 Leonberg (DE)
(74) Representative: Schäfer, Wolfgang

(57) **Abstract**

The present invention relates to a radio frequency transmitter (1) comprising an I/Q modulator (2) for obtaining a modulated output signal (2a) from an in-phase signal (I) and a quadrature phase signal (Q), and an I/Q modulator control loop (3b, 3c) controlling (130) said I/Q modulator (2), characterized by an activation switch (3a) capable of activating/deactivating said I/Q modulator control loop (3b, 3c).

The present invention also relates to a method of operating a radio frequency transmitter (1) comprising an I/Q modulator (2) for obtaining a modulated output signal (2a) from an in-phase signal (I) and a quadrature phase signal (Q), an I/Q modulator control loop (3b, 3c) controlling (130) said I/Q modulator (2), characterized by activating (120) said I/Q modulator control loop (3b, 3c) if a suitable calibration signal is supplied to said transmitter (1).

## Description

The present invention relates to a radio frequency transmitter comprising an I/Q modulator for obtaining a modulated output signal from an in-phase signal and a quadrature phase signal and an I/Q modulator control loop controlling said I/Q modulator.

The present invention further relates to a method of operating a radio frequency transmitter comprising an I/Q modulator for obtaining a modulated output signal from an in-phase signal and a quadrature phase signal, and an I/Q modulator control loop controlling said I/Q modulator.

Radio frequency transmitters of the aforementioned type are e.g. known from state of the art GSM (Global System for Mobile communications) base transceiver stations (BTS) which are part of a radio sub-system of a GSM communications network.

The main disadvantage of prior art I/Q modulator control loops which perform a so-called on-line control, i.e. a permanent control while regular operation, of said I/Q modulators provided in said base transceiver stations is the complex and expensive hardware required for implementing I/Q modulator control mechanisms which are capable of performing an efficient I/Q modulator control based on arbitrary input signals of said transmitter.

Said I/Q modulator control is crucial for proper I/Q modulator operation since I/Q modulators are subject to several errors such as a quadrature error, which is characterized by a phase difference of said in-phase signal and said quadrature phase signal not equal to 90 degrees.

A further common error of I/Q modulators is a so-called gain imbalance, in which a relation of amplitudes of said in-phase signal and said quadrature phase signal does not have a desired value. There are still further common errors of I/Q modulators which relate to an undesired DC voltage offset of said in-phase signal and said quadrature phase signal.

Hence, it is an object of the present invention to improve a radio frequency transmitter and a method of operating a radio frequency transmitter of the above mentioned type.

Regarding the radio frequency transmitter, this object is achieved by providing an activation switch which is capable of activating/deactivating said I/Q modulator control loop, which enables to operate said I/Q modulator control loop whenever necessary.

Furthermore, it is possible to restrict the operation of said I/Q modulator control loop to such situations in which there is a suitable input signal provided at an input of said radio frequency transmitter, i.e. an input signal which allows for computationally easy I/Q modulator control.

An advantageous embodiment of the present invention is characterized by a calibration signal generator which generates an internal calibration signal that can be supplied to said transmitter. This way, it is possible to perform an I/Q modulator control despite the absence of a suitable input signal provided externally. Preferably, said calibration signal generator is used for generating an internal calibration signal if there is an idle time slot which is not transmitted over the air.

A further embodiment of the present invention is characterized by being capable of using a frequency correction burst of an input signal as said calibration signal.

Said frequency correction burst is e.g. used within GSM systems and it is transmitted periodically via a so-called broadcast control channel (BCCH).

Said frequency correction burst has defined contents and thus allows for a computationally easy and inexpensive control of said I/Q modulator without requiring any extra effort of providing an externally generated calibration signal or even turning off said radio frequency transmitter for proper calibration.

Said computationally easy and inexpensive control according to the present invention is achieved by advantageously using the fact that (at least parts) of i.e. said frequency correction burst or any other suitable calibration signal do effect a modulated output signal at an output of said I/Q modulator which has a constant absolute value of its complex envelope if there is none of the above mentioned typical errors of said I/Q modulator.

I.e. a proper operation of said I/Q modulator can easily be verified by checking the complex envelope of said modulated output signal for a constant absolute value.

A very advantageous variant of the present invention is characterized by said modulator control loop comprising an amplitude detector and/or an I/Q correction circuit.

Said amplitude detector is used to check the complex envelope of said modulated output signal for a constant absolute value which indicates an error-free operation of said I/Q modulator. If said amplitude detector detects a non-constant absolute value of said complex envelope, said I/Q correction circuit is triggered.

Another advantageous embodiment of the present invention comprises a digital filter capable of influencing a DC offset voltage of said in-phase signal and/or said quadrature phase signal, and/or capable of influencing a gain of said in-phase signal and/or said quadrature phase signal, and/or capable of influencing a phase difference between said in-phase signal and said quadrature phase signal.

Said digital filter is i.e. controlled by said I/Q correction circuit to influence said in-phase signal and/or said quadrature phase signal accordingly to achieve a constant absolute value of said complex envelope as explained above.

Said digital filter may e.g. comprise gain correction means for altering at least a gain of one of said in-phase signal and said quadrature phase signal, further phase correction means for altering a phase difference between said in-phase signal and said quadrature phase signal, and said digital filter may, too, comprise DC offset adjustment means for adjusting a DC offset of said in-phase signal and/or said quadrature phase signal.

A further solution to the object of the present invention regarding to said method of operating a radio frequency transmitter is given by activating said I/Q modulator control loop if a suitable calibration signal is supplied to said transmitter.

According to one embodiment of the present invention, a frequency correction burst of an input signal is used as said calibration signal. Said frequency correction burst is e.g. used within GSM systems and it is transmitted periodically via a so-called broadcast control channel as already explained above.

According to a further advantageous embodiment of the present invention, an internal calibration signal is generated. This is especially advantageous if an input signal to said radio frequency transmitter does not comprise a suitable calibration signal.

This may e.g. be the case with an input signal that does not effect a modulated output signal to have a complex envelope with a constant absolute value at an output of said I/Q modulator. Such an input signal usually leads to a non-constant absolute value of said complex envelope which drastically complicates the process of controlling said I/Q modulator. Then, a simple amplitude detector would not be sufficient for verifying proper operation of said I/Q modulator any more. This is avoided according to the present invention by using a proper calibration signal allowing for a computationally easy I/Q modulator control by means of an amplitude detector.

According to the present invention, said internal calibration signal is supplied to said transmitter whenever there is an idle time slot. During such idle time slots, no user data or system data is to be transferred via said radio frequency transmitter and thus an I/Q modulator control can be performed without affecting regular communication of said transmitter.

A further very advantageous embodiment of the present invention is characterized in that said calibration signal effects a modulated output signal a complex envelope of which has a constant absolute value. This is - as already explained above - e.g. achieved by using said frequency correction burst. Alternatively, any other input signals comprising long sequences of constant data value such as logical "0" or "1" can be used.

A further advantageous embodiment of the present invention is characterized in that an I/Q correction circuit controls a digital filter so as to obtain a modulated output signal a complex envelope of which has a constant absolute value, if said calibration signal is supplied to said transmitter.

The control of said digital filter is an iterative process in which e.g. firstly only one parameter of said filter is altered thereby influencing a gain of said in-phase signal. If said I/Q modulator control loop thereupon detects an improvement of said modulated output signal, said altering of said one parameter is continued until a desired improvement is achieved. Alternatively, other parameters of said digital filter may be influenced thus altering a phase difference or a DC offset voltage as described beforehand.

Yet a further advantageous embodiment of the present invention is characterized in that a calibration signal generator is used for generating an internal calibration signal, in particular if there is an idle time slot which is not transmitted over the air.

Further details and advantages of the present invention are presented in the following detailed description with reference to the drawings, in which:
- Figure 1: depicts a block diagram of a first embodiment of the present invention,
- Figure 2: depicts a block diagram of a second embodiment of the present invention, and
- Figure 3: depicts a flow chart of a third embodiment of the present invention.

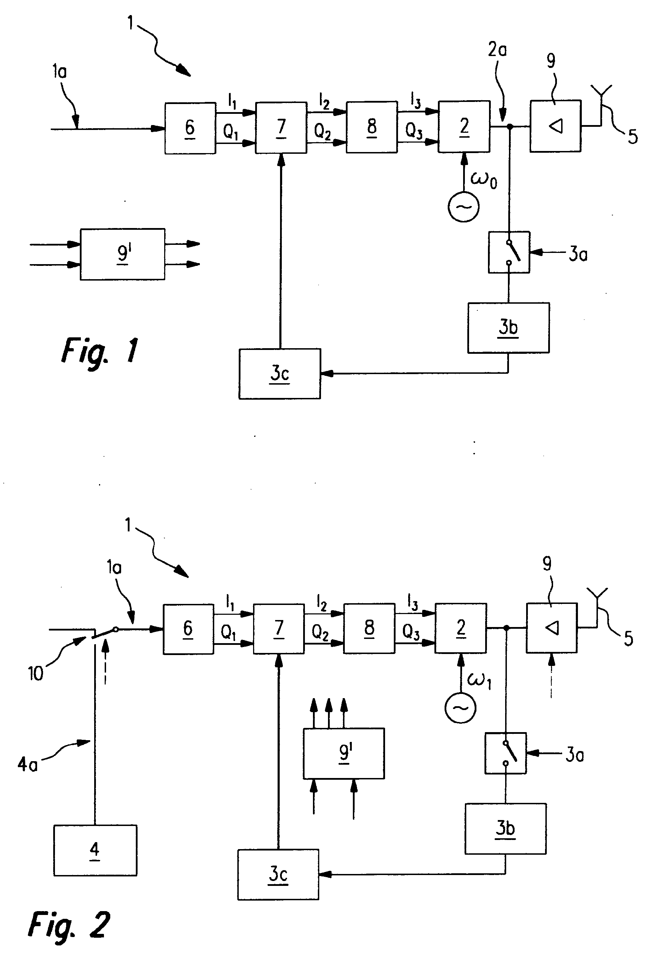

Fig. 1 shows a radio frequency transmitter 1 which is provided with an input signal 1a at its input, and which outputs an amplified modulated output signal 2a to an antenna 5.

Said transmitter 1 is used within a GSM (Global System for Mobile communications) base transceiver station (BTS, not shown) to transmit said amplified modulated output signal 2a via said antenna 5 to mobile terminals which are not shown in Fig. 1 and which are capable of performing GSM standard communications. An operation of said transmitter 1 is controlled by a common control logic 9' receiving input signals and producing corresponding output signals both of which are symbolized by arrows pointing to or originating from said common control logic 9'.

Prior to a process of I/Q modulation in an I/Q modulator 2, said input signal 1a is processed by a GMSK (Gaussian Minimum Shift Keying) modulator 6 which is also known from prior art (e.g. K.D. Kammeyer: Nachrichtenuebertragung, B.G. Teubner, Stuttgart, 1996, p. 389) and which is used by GSM communications systems. Said GMSK modulator 6 provides at its outputs an in-phase signal I₁ and a quadrature phase signal Q₁ both of which are fed into a digital filter 7 for digitally filtering said in-phase signal I₁ and said quadrature phase signal Q₁.

Said process of digital filtering in this context comprises influencing a DC offset voltage of said in-phase signal I₁ and/or said quadrature phase signal Q₁, and/or influencing a gain of said in-phase signal I₁ and/or said quadrature phase signal Q₁, and/or influencing a phase difference between said in-phase signal I₁ and said quadrature phase signal Q₁.

After the aforementioned step of digitally filtering, said in-phase signal I₂ and said quadrature phase signal Q₂ are converted by a D/A (Digital to Analog) converter 8 which outputs an analog in-phase signal I₃ and an analog quadrature phase signal Q₃ to said I/Q modulator 2.

Hereafter, the I/Q modulator 2 performs said I/Q modulation, based on a carrier signal having a first angular frequency ω₀. Said first angular frequency ω₀ corresponds to a frequency channel according to a GSM frequency division multiplex (FDM) scheme.

Said I/Q modulator 2 outputs a modulated output signal 2a, which is passed over to an output amplifier 9, said output amplifier 9 being connected to an antenna 5 as already stated above.

As can be seen from Fig. 1, said modulated output signal 2a is also provided to an activation switch 3a, which is used to activate or deactivate, respectively, an I/Q modulator control loop comprising an amplitude detector 3b and an I/Q correction circuit 3c.

Said I/Q modulator control loop 3b, 3c controls said digital filter 7 and can thus influence an operation of said I/Q modulator 2.

By activating/deactivating said activation switch 3a, it is possible to enable/disable an I/Q modulator control performed by said I/Q modulator control loop 3b, 3c.

According to the present invention, said activation switch 3a is used to activate said I/Q modulator control loop 3b, 3c whenever said input signal 1a of said radio frequency transmitter 1 comprises a suitable calibration signal such as a frequency correction burst which is used within GSM communication systems to e.g. synchronize mobile terminals.

For instance, said frequency correction burst is transmitted periodically within GSM systems in a broadcast control channel (BCCH), and by activating said I/Q modulator control loop 3b, 3c accordingly, a desired I/Q modulator control can also be performed periodically based on evaluating said modulated output signal 2a.

Said frequency correction burst has defined contents and thus allows for a computationally easy and inexpensive control of said I/Q modulator 2 since I/Q modulation of said frequency correction burst yields a modulated output signal 2a which has a complex envelope, an absolute value of which is constant, provided proper I/Q modulator operation.

It is also possible to use other types of input signals 1a of said radio frequency transmitter 1 which are suitable for a proper I/Q modulator control loop operation without requiring extra hardware. Preferably, these other types of input signals 1a do also yield a modulated output signal 2a which has a complex envelope, wherein said complex envelope has a constant absolute value.

Said constant absolute value of said envelope is monitored by said amplitude detector 3b. If said amplitude detector 3b detects a non-constant absolute value of said envelope, it triggers said I/Q correction circuit 3c which thereupon controls said digital filter 7 accordingly.

This leads to an iterative process in which firstly only one parameter of said digital filter 7 is altered thereby influencing a gain of said in-phase signal I₂. If said I/Q modulator control loop 3b, 3c thereupon detects an improvement of said modulated output signal 2a, e.g. an improvement of a desired ratio of amplitudes of said in-phase signal I₂ and said quadrature phase signal Q₂, said altering of said one parameter is continued until a desired ratio is achieved.

Alternatively, other parameters of said digital filter 7 may be influenced thus altering a phase difference between said in-phase signal I₂ and said quadrature phase signal Q₂ or altering a DC offset voltage of said in-phase signal I₂ and/or said quadrature phase signal Q₂.

Thereby, it is possible to eliminate a quadrature error and/or an imbalance error and/or a DC voltage offset error of said in-phase signal I₂ and/or said quadrature phase signal Q induced by said I/Q modulator 2.

Since only an absolute value of said envelope is to be monitored, a simple amplitude detector 3b in conjunction with said I/Q correction circuit 3c and said activation switch 3a is sufficient for an effective on-line control of said I/Q modulator 2 without requiring further complex and expensive hardware and/or computational power.

If there is no suitable calibration signal supplied as an input signal 1a to said radio frequency transmitter 1, said activation switch 3a is opened so as to prevent operation of said I/Q modulator control loop 3b, 3c.

Fig. 2 depicts a block diagram of a second embodiment of the transmitter according to the present invention, which basically comprises the same elements 2, 3a, 3b, 3c, 5, 6, 7, 8, 9, 9' .

As a difference to the first embodiment of the present invention described with reference to Fig. 1, said radio frequency transmitter 1 according to Fig. 2 comprises a calibration signal generator 4, which may be connected to an input of said GMSK modulator 6 instead of a regular input signal 1a of said radio frequency transmitter 1 so as to provide an internally generated calibration signal 4a as an input signal 1a to said radio frequency transmitter 1.

Said internally generated calibration signal 4a can be used as a suitable calibration signal e.g. in cases in which said regular input signal 1a of said radio frequency transmitter 1 does not comprise a suitable calibration signal such as a frequency correction burst known from GSM systems.

By means of a switch 10 said signal generator 4 can be connected to said input of the GMSK modulator 6. If no internally generated calibration signal 4a is required, said switch 10 connects said input of the GMSK modulator 6 to a source of the regular input signal 1a, and simultaneously, said calibration signal generator 4 is disconnected from the input of the GMSK modulator 6.

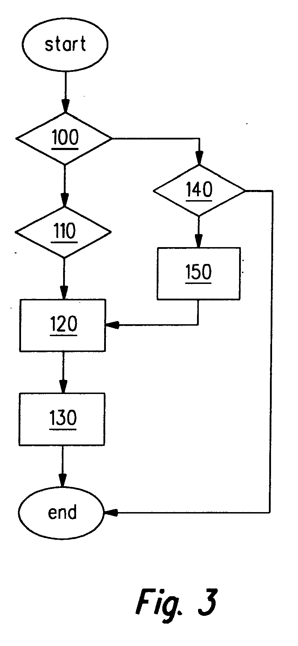

A method of operating a radio frequency transmitter 1 as explained according to Fig. 1 or Fig. 2 is further detailed by the flow chart of Fig. 3.

In step 100 said input signal 1a (cf. Fig. 1, 2) is tested for comprising a proper calibration signal such as the above mentioned frequency correction burst which can be used by said I/Q modulator control loop 3b, 3c to calibrate an I/Q modulator operation.

If said input signal 1a comprises a proper calibration signal, a further test is performed in step 110, which determines whether momentarily a calibration signal is available at an input of said radio frequency transmitter 1.

If a proper calibration signal is momentarily available, it is proceeded to step 120, in which said I/Q modulator control loop 3b, 3c is activated by closing activation switch 3a (Fig. 1, 2). After that, a proper controlling 130 of said I/Q modulator 2 by said I/Q modulator control loop 3b, 3c is possible and may periodically be restarted in accordance with the method previously described.

If there is no proper calibration signal contained within said input signal 1a of said radio frequency transmitter 1 (Fig. 1, 2) when performing the test according to step 100, it is determined in step 140, whether currently there is an idle time slot of said input signal 1a and, if an idle time slot is available, which is not transmitted over the air, a calibration signal 4a is internally generated by a calibration signal generator 4 (Fig. 2) within step 150 and connected to said input of said GMSK modulator 6 instead of said regular input signal 1a. The connection is established by said switch 10 (Fig. 2).

After that, said I/Q modulator control loop 3b, 3c is activated within step 120 as explained above, and a proper monitoring of said I/Q modulator is performed within step 130. If there is no idle time slot when performing the test according to step 140, no further steps are performed.

## Claims

1. Radio frequency transmitter (1) comprising an I/Q modulator (2) for obtaining a modulated output signal (2a) from an in-phase signal (I) and a quadrature phase signal (Q), and an I/Q modulator control loop (3b, 3c) controlling (130) said I/Q modulator (2), **characterized by** an activation switch (3a) capable of activating/deactivating said I/Q modulator control loop (3b, 3c).

2. Radio frequency transmitter (1) according to claim 1, **characterized by** a calibration signal generator (4) which generates an internal calibration signal (4a) that can be supplied to said transmitter (1).

3. Radio frequency transmitter (1) according to claim 1 or 2, **characterized by** being capable of using a frequency correction burst of an input signal (1a) as said calibration signal.

4. Radio frequency transmitter (1) according to one of the preceding claims, **characterized in that** said I/Q modulator control loop (3b, 3c) comprises an amplitude detector (3b) and/or an I/Q correction circuit (3c).

5. Radio frequency transmitter (1) according to one of the preceding claims, **characterized by** a digital filter (7) capable of influencing a DC offset voltage of said in-phase signal (I) and/or said quadrature phase signal (Q), and/or capable of influencing a gain of said in-phase signal (I) and/or said quadrature phase signal (Q), and/or capable of influencing a phase difference between said in-phase signal (I) and said quadrature phase signal (Q).

6. Method of operating a radio frequency transmitter (1) comprising an I/Q modulator (2) for obtaining a modulated output signal (2a) from an in-phase signal (I) and a quadrature phase signal (Q), and an I/Q modulator control loop (3b, 3c) controlling (130) said I/Q modulator (2), **characterized by** activating (120) said I/Q modulator control loop (3b, 3c) if a suitable calibration signal is supplied to said transmitter (1).

7. Method according to claim 6, **characterized by** using a frequency correction burst of an input signal (1a) as said calibration signal.

8. Method according to one of the claims 6 to 7, **characterized by** generating (150) an internal calibration signal (4a).

9. Method according to one of the claims 6 to 8, **characterized in that** said calibration signal effects a modulated output signal (2a) a complex envelope of which has a constant absolute value.

10. Method according to one of the claims 6 to 9, **characterized in that** an I/Q correction circuit (3c) controls a digital filter (7) so as to obtain a modulated output signal (2a) a complex envelope of which has a constant absolute value, if said calibration signal is supplied to said transmitter (1) .

11. Method according to one of the claims 6 to 10, **characterized in that** a calibration signal generator (4) is used for generating an internal calibration signal (4a), in particular if there is an idle time slot which is not transmitted over the air.
